# EUROPEAN PATENT SPECIFICATION

(11) **EP 3 089 172 B1**
(45) Date of publication and mention of the grant of the patent: **01.05.2019**
(21) Application number: 14874229.9
(22) Date of filing: 24.12.2014
(51) Int. Cl.: H01B 12/06, C23C 14/08, H01B 13/00, H01F 6/06, H01L 39/24

(54) **OXIDE SUPERCONDUCTING WIRE MATERIAL AND OXIDE SUPERCONDUCTING WIRE MATERIAL MANUFACTURING METHOD**
SUPRALEITENDES OXIDDRAHTMATERIAL UND HERSTELLUNGSVERFAHREN FÜR SUPRALEITENDES OXIDDRAHTMATERIAL
MATÉRIAU DE FIL SUPRACONDUCTEUR D'OXYDE ET FABRICATION DE MATÉRIAU DE FIL SUPRACONDUCTEUR D'OXYDE

(30) Priority: 25.12.2013 JP 2013267921
(43) Date of publication of application: 02.11.2016
(73) Proprietor: Fujikura Ltd., Tokyo 135-8512 (JP)
(72) Inventor: KURIHARA Chihaya, Sakura-shi Chiba 285-8550 (JP); NAKAMURA Naonori, Sakura-shi Chiba 285-8550 (JP)
(74) Representative: Cabinet Plasseraud
(86) International application number: PCT/JP2014/084089
(87) International publication number: WO 2015/098934

(56) References cited:
- WO-A1-2013/129568
- WO-A1-2013/129568
- JP-A- 2012 043 734
- JP-A- 2013 012 321
- JP-A- 2013 097 889
- JP-A- 2013 134 856

## Description

### TECHNICAL FIELD

The present invention relates to an oxide superconducting wire and an oxide superconducting wire manufacturing method.

Priority is claimed on Japanese Patent Application No. 2013-267921, filed December 25, 2013.

### BACKGROUND ART

RE 123-based oxide superconductors have a composition represented as RE₁Ba₂Cu₃O_{7-δ} (RE: a rare earth element such as Y and Gd), and have a critical temperature that is higher than a liquid nitrogen temperature (77K). Research on applications of such oxide superconductors in various superconducting devices, for example, superconducting magnets and transformers, current limiting devices, and motors, has been conducted in many places.

Generally, in order to use the oxide superconductors for various superconducting devices, an oxide superconductor is processed into a wire and used as a conductor for a power supply or an oxide superconducting wire such as a magnetic coil. The oxide superconducting wire is formed such that an oxide superconducting layer made of the oxide superconductor is deposited on a tape-shaped substrate through an intermediate layer.

It is known that, when the oxide superconductor is exposed to a humid environment, a crystal structure is disarrayed due to an influence of moisture, and a superconducting characteristic deteriorates. In addition, when a distortion or a crack occurs in the oxide superconductor due to a load from the outside, there is a risk of the superconducting characteristic deteriorating.

Accordingly, a technology in which a protective layer covering a surface is formed on the oxide superconducting wire to protect an oxide superconducting layer from an influence of moisture or a load from the outside is disclosed (for example, Patent Literature 1). It is known that Ag or an Ag alloy having low reactivity with the oxide superconducting layer is used as the protective layer.

### PRIOR ART DOCUMENTS

### PATENT DOCUMENTS

[Patent Literature 1] Japanese Unexamined Patent Application, First Publication No. H 7-105751
[Patent Literature 2] Patent Application WO 2013 129568
[Patent Literature 3] Japanese Patent Application JP 2013 134856

### SUMMARY OF THE INVENTION

### PROBLEMS TO BE SOLVED BY THE INVENTION

It is necessary for an oxide superconducting wire to be subjected to an oxygen annealing treatment through which a superconducting characteristic is improved by supplying oxygen to an oxide superconducting layer after a protective layer is formed. The oxygen annealing treatment is performed such that the oxide superconducting wire is heated at 300 °C to 500 °C under an oxygen atmosphere. According to the heating, Ag atoms of the protective layer may aggregate on a surface of the oxide superconducting layer, and become a plurality of Ag particle aggregates that are isolated and dispersed. As a result, a thick part or a thin part may occur locally in the protective layer, and a pinhole may occur in the protective layer.

When a pinhole occurs, it is not possible to perform a function of the protective layer since moisture penetrates through the pinhole. In order to limit the pinhole, it is necessary to form a thick protective layer. However, since Ag is an expensive metal, it is preferable that the amount of Ag used be reduced.

The present invention has been made in view of the above-described problems and an object of the present invention is to provide an oxide superconducting wire including a protective layer having no pinhole while limiting the amount of Ag used and an enhanced function of protecting an oxide superconducting layer.

### MEANS FOR SOLVING THE PROBLEMS

In order to address the above problems, an oxide superconducting wire according to a first aspect of the present invention includes an oxide superconducting laminate, the oxide superconducting laminate including: an intermediate body having a tape-shaped substrate, an intermediate layer formed on a main surface of the substrate, and an oxide superconducting layer formed on the intermediate layer; and a protective layer formed on the intermediate body. An average film thickness Tₐᵥₑ of the protective layer is 0.1 µm to 5 µm. The ratio T_{σ}/Tₐᵥₑ between a standard deviation T_{σ} and the average film thickness Tₐᵥₑ of a film thickness of the protective layer is 0.4 or less.

In the first aspect, the protective layer may be made of Ag or an Ag alloy. The protective layer has an average film thickness Tₐᵥₑ that is set to 0.1 µm to 5 µm. The ratio T_{σ}/Tₐᵥₑ between the standard deviation T_{σ} and the average film thickness Tₐᵥₑ of the film thickness is set to 0.4 or less. Therefore, it is possible to limit a pinhole from being formed without forming an excessively thick protective layer. Accordingly, it is possible to reduce the cost of the protective layer while sufficiently performing a protective function.

In the oxide superconducting wire according to the above aspect, a metal tape is adhered to the protective layer by soldering. Therefore, it is possible to stabilize a current characteristic. In addition, a pair of oxide superconducting wires according to the above aspect are prepared, and protective layers are set to face and can be connected by soldering. In these cases, solder is directly adhered to the protective layer. When the solder is adhered to the protective layer, a metal (as an example, Sn) of the solder moves into the protective layer, and Ag of the protective layer is formed into an alloy. When Ag is formed into the alloy, sometimes it becomes brittle. When the protective layer has a local thin part, the protective layer becomes brittle in the overall thickness direction in the thin part, and the protective layer itself becomes easy to be peeled off. Accordingly, the metal tape described above is likely to be peeled off, and the strength of a connection part decreases.

According to the above aspect of the present invention, the protective layer has the average film thickness Tₐᵥₑ that is set to 0.1 µm to 5 µm, and the ratio T_{σ}/Tₐᵥₑ between the standard deviation T_{σ} and the average film thickness Tₐᵥₑ of the film thickness is set to 0.4 or less. Therefore, since the protective layer has no local thin part even when brittleness is caused due to alloying, the brittleness does not extend in the overall thickness direction of the protective layer. Accordingly, it is possible to limit the strength (the strength of the connection part or the peel strength of the metal tape) from decreasing.

In addition, in the oxide superconducting wire, a plating coating layer is provided along an outer circumference of the oxide superconducting laminate, and therefore it is possible to stabilize a current characteristic. In this case, the oxide superconducting wire is immersed in a plating solution to form the plating coating layer. Since formation of a pinhole is limited in the protective layer, there is no corrosion of the oxide superconducting layer, which is caused when the plating solution comes in contact with the oxide superconducting layer. Accordingly, it is possible to prevent the superconducting characteristic from decreasing.

In addition, the oxide superconducting wire according to the first aspect may further include a stabilizing layer that is bonded to the protective layer and formed of a metal tape.

In addition, the oxide superconducting wire according to the first aspect may further include a stabilizing layer that is formed along the outer circumference of the oxide superconducting laminate and formed of the plating coating layer.

When the stabilizing layer is formed, it is possible to stabilize a current characteristic of the oxide superconducting wire. When the stabilizing layer is formed to cover the outer circumference of the oxide superconducting wire, the oxide superconducting layer is sealed from the outside. Therefore, it is possible to prevent a superconducting characteristic from deteriorating due to moisture penetration. In the first aspect, the protective layer may be formed after the intermediate body is subjected to an oxygen annealing treatment.

In the related art, since the oxygen annealing treatment is performed after the protective layer is formed, an aggregation of Ag is caused due to heat resulting from the oxygen annealing treatment, and a local thin part occurs or a pinhole is formed in the protective layer. However, since the protective layer is formed after the oxygen annealing treatment is performed, an aggregation or recrystallization of Ag is limited. Therefore, it is possible to implement the protective layer having a uniform film thickness.

In the first aspect, the protective layer has a surface whose arithmetic average roughness Ra may be 80 nm or less.

An oxide superconducting wire manufacturing method according to a second aspect of the present invention includes preparing an intermediate body including a substrate, an intermediate layer formed on the substrate, and an oxide superconducting layer formed on the intermediate layer, performing an oxygen annealing treatment on the intermediate body, and forming a protective layer on the oxide superconducting layer after the oxygen annealing treatment is performed.
In the second aspect, the protective layer may be made of Ag or an Ag alloy.
In the related art, since the oxygen annealing treatment is performed after the protective layer is formed, an aggregation of Ag is caused due to heat resulting from the oxygen annealing treatment, and a local thin part occurs or a pinhole is formed in the protective layer. However, since the protective layer is formed after the oxygen annealing treatment is performed, an aggregation or recrystallization of Ag is limited. Therefore, it is possible to implement the protective layer having a uniform film thickness.

In addition, in the second aspect, when the protective layer is formed, after the protective layer having an average film thickness of 5 µm or less is formed by a sputtering method, the oxide superconducting wire may be subjected to cooling or heat dissipation.

In addition, in the second aspect, when the protective layer is formed, a process in which the protective layer having an average film thickness of 5 µm or less is formed by a sputtering method and a process in which the oxide superconducting wire is subjected to cooling or heat dissipation may be repeatedly performed.

In a film formation by the sputtering method, when sputtered particles (Ag particles) collide with a body to be coated, kinetic energy at the time of collision is converted into thermal energy, and the temperature of a surface of the body to be coated increases. When the temperature of the oxide superconducting layer serving as the body to be coated increases, there is a risk that oxygen in the oxide superconducting layer leaks and a superconducting characteristic deteriorates. Since the thickness of the protective layer formed during a single film formation process is set to 5 µm or less, it is possible to limit oxygen from leaking from the oxide superconducting layer and prevent the superconducting characteristic from deteriorating.

In the second aspect, an arithmetic average roughness Ra of the protective layer may be 80 nm or less.

### EFFECTS OF THE INVENTION

According to the above aspects of the present invention, the protective layer has an average film thickness Tₐᵥₑ of 0.1 µm to 5 µm, and the ratio T_{σ}/Tₐᵥₑ between the standard deviation T_{σ} and the average film thickness Tₐᵥₑ of the film thickness of the protective layer is 0.4 or less.

That is, neither an extremely thick part nor an extremely thin part is formed in the protective layer. Accordingly, even when the protective layer is formed to be thin, a pinhole is less likely to be formed. In addition, since no local thin part occurs in the protective layer even when solder is bonded to the protective layer, it is possible to limit the protective layer from being alloyed in the overall thickness direction and becoming brittle. Accordingly, the peel strength of the protective layer itself is less likely to be reduced.

Accordingly, it is possible to provide the oxide superconducting wire through which a cost of the protective layer is reduced while sufficiently performing a protective function of the oxide superconducting layer.

### BRIEF DESCRIPTION OF THE DRAWINGS

Fig. 1 is an inclined cross-sectional view schematically showing an oxide superconducting wire according to a first embodiment of the present invention.
Fig. 2 is an inclined cross-sectional view schematically showing an oxide superconducting wire according to a second embodiment of the present invention.
Fig. 3 is an inclined cross-sectional view schematically showing an oxide superconducting wire according to a third embodiment of the present invention.
Fig. 4 shows a scanning electron microscope (SEM) image of a cross section of a protective layer of an oxide superconducting wire according to an example.
Fig. 5 shows an SEM image of a cross section of a protective layer of an oxide superconducting wire according to a comparative example.

### DETAILED DESCRIPTION OF THE INVENTION

Hereinafter, embodiments of an oxide superconducting wire according to the present invention will be described based on the drawings. Note that, in the drawings used in the following description, in order to facilitate understanding of features, feature parts are enlarged for convenience of illustration in some cases, and dimensional ratios of components are not necessarily the same as actual ones. In addition, the present invention is not limited to the following embodiments.

### <First embodiment>

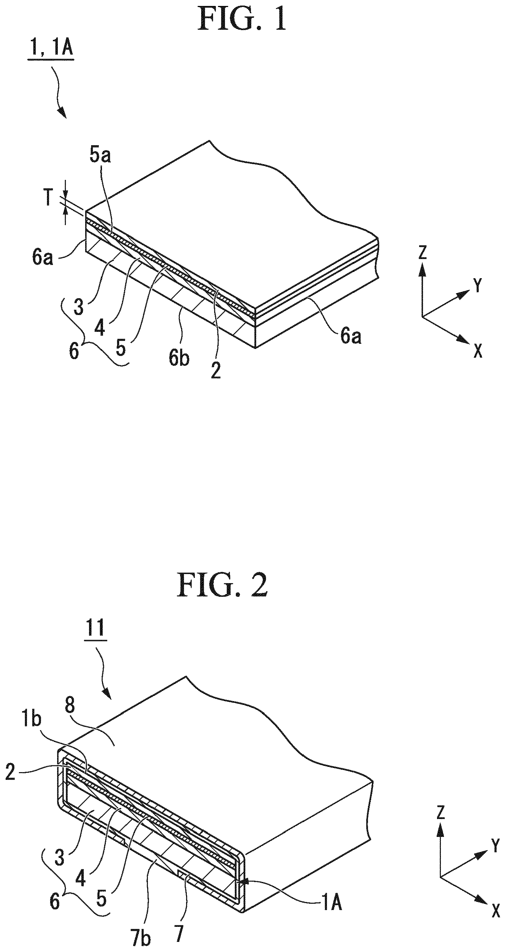

Fig. 1 is a schematic diagram showing a cross section of an oxide superconducting wire 1 according to a first embodiment of the present invention. The oxide superconducting wire 1 of the present embodiment has an oxide superconducting laminate 1A that includes an intermediate body 6 in which an intermediate layer 4 and an oxide superconducting layer 5 are laminated on a tape-shaped substrate 3, and a protective layer 2 that is formed on a main surface (a first surface) 5a of the oxide superconducting layer 5 of the intermediate body 6.

In the drawings in this specification, a width direction of the wire is defined as an X direction, a longitudinal direction is defined as a Y direction, and a thickness direction is defined as a Z direction.

As a material of the substrate 3, a nickel alloy which is represented by HASTELLOY (registered trademark, commercially available from Haynes International, Inc. USA), or stainless steel and an oriented Ni-W alloy obtained by introducing an aggregate structure to a nickel alloy are applied. The substrate 3 has a thickness that may be appropriately adjusted according to a purpose, and can be set to a range of 10 to 500 µm.

The intermediate layer 4 formed on the substrate 3 may have, for example, a structure including a diffusion preventing layer, a bed layer, a textured layer and a cap layer which are sequentially laminated from a substrate side. The intermediate layer 4 may have a configuration in which either or both of the diffusion preventing layer and the bed layer are not provided.

The diffusion preventing layer is made of Si₃N₄, Al₂O₃, GZO (Gd₂Zr₂O₇) or the like. The diffusion preventing layer is formed to have a thickness of, for example, 10 to 400 nm. The bed layer is a layer that decreases interfacial reactivity, is formed to obtain an orientation property of a film formed on the bed layer, and is made of Y₂O₃, Er₂O₃, CeO₂, Dy₂O₃, Er₂O₃, Eu₂O₃, Ho₂O₃, La₂O₃ or the like. The bed layer has a thickness that is, for example, 10 to 100 nm. The textured layer is made of a biaxially oriented substance in order to control a crystal orientation property of the cap layer on the textured layer. As a material of the textured layer, a metal oxide such as Gd₂Zr₂O₇, MgO, ZrO₂-Y₂O₃ (YSZ), SrTiO₃, CeO₂, Y₂O₃, Al₂O₃, Gd₂O₃, Zr₂O₃, Ho₂O₃, and Nd₂O₃ are exemplary examples.

The textured layer is preferably formed by an ion beam assisted deposition (IBAD) method.

The cap layer is deposited on a surface of the above-described textured layer and made of a material whose crystal particles are capable of orienting themselves in an in-plane direction. Specifically, the cap layer is made of CeO₂, Y₂O₃, Al₂O₃, Gd₂O₃, ZrO₂, YSZ, Ho₂O₃, Nd₂O₃, LaMnO₃ or the like. The cap layer can be formed to have a film thickness in the range of 50 to 5000 nm.

As a material of the oxide superconducting layer 5, a known oxide superconducting material may be used. Specifically, REBa₂Cu₃O_{y} (RE represents one, two or more of Sc, Y, La, Ce, Pr, Nd, Pm, Sm, Eu, Gd, Tb, Dy, Ho, Er, Tm, Yb, and Lu, which are rare earth elements) called RE-123 series are exemplary examples. As the oxide superconducting layer 5, Y123 (YBa₂Cu₃O_{7-X}) and Gd123 (GdBa₂Cu₃O_{7-X}) are exemplary examples. Preferably, the oxide superconducting layer 5 has a thickness of about 0.5 to 5 µm and has a uniform thickness.

After forming the oxide superconducting layer, a heat treatment is performed on the oxide superconducting layer 5 at 300 to 500 °C for 5 to 20 h under an oxygen atmosphere (an oxygen annealing treatment). The oxide superconducting layer 5 has a crystal structure in which oxygen is insufficient after being formed. Therefore, when the above oxygen annealing treatment is performed, oxygen is supplied to the oxide superconducting layer 5 and the crystal structure can be arranged. According to the present embodiment, when the oxygen annealing treatment is performed on the intermediate body 6, the oxide superconducting layer 5 undergoes the oxygen annealing treatment.

The protective layer 2 is a layer that is formed on a main surface 5a of the oxide superconducting layer 5 and made of Ag or an Ag alloy. The protective layer 2 may be formed not only on the main surface 5a, but also on side surfaces 6a and 6a and a rear surface 6b of the intermediate body 6. In particular, when the protective layer 2 is formed by a sputtering method, since some sputtered particles (Ag particles) go around the side surface 6a and the rear surface 6b of the intermediate body 6, the thin protective layer 2 is also formed on the side surface 6a and the rear surface 6b of the intermediate body 6. In Fig. 1, the protective layer 2 formed on the side surface 6a and the rear surface 6b is not shown.

The protective layer 2 protects the oxide superconducting layer 5. In addition, the protective layer 2 bypasses an overcurrent that is generated at the time of an accident. In addition, the protective layer 2 has a function of limiting a chemical reaction between the oxide superconducting layer 5 and a layer provided on a surface upper than the oxide superconducting layer 5 from occurring and preventing a superconducting characteristic from decreasing, which is caused when some elements of one layer penetrate into another layer and a composition is changed.

The protective layer 2 can be formed at room temperature by a film formation method such as the sputtering method. An example of a film formation of the protective layer 2 by the sputtering method will be described below. First, a target made of Ag or an Ag alloy and the intermediate body 6 are disposed inside a processing container in which a pressure of an inside is reduced to a vacuum state and Ar gas is introduced. In this case, the oxide superconducting layer 5 is disposed toward to the target. Next, as a voltage is applied to the target and discharge is performed, Ar gas is ionized and plasma is generated. Ar ions generated in the plasma sputter the target, and sputtered Ag particles are ejected from the target. Then, when the sputtered particles are deposited on the oxide superconducting layer 5, the protective layer 2 is formed.

The protective layer 2 of Ag that is formed at room temperature by the sputtering method includes an amorphous structure (an amorphous material) as a main body and has a uniform film thickness. However, when the protective layer 2 is heated to a recrystallization temperature of 200 °C or more, an aggregation occurs due to a recrystallization of Ag. When the protective layer 2 is heated to 450 °C or more, the aggregation becomes more significant. When the aggregation of Ag occurs, the film thickness of the protective layer 2 becomes nonuniform and a local thin part or a pinhole is generated. Accordingly, the formation of the protective layer 2 is preferably performed after the oxygen annealing treatment in which a heat treatment is performed at 300 °C or more.

In a film formation by the sputtering method, when the sputtered particles (the Ag particles) collide with a body to be coated (the oxide superconducting layer 5 and the substrate 3), kinetic energy at the time of collision is converted into thermal energy, and a temperature of a surface of the body to be coated increases. When a temperature of the oxide superconducting layer 5 serving as the body to be coated increases under a reduced pressure atmosphere, there is a risk of oxygen in the oxide superconducting layer 5 leaking, a crystal structure being disarranged, and a superconducting characteristic deteriorating.

An increase in the temperature of the body to be coated has a correlation with the film thickness of the protective layer 2 that is formed at one time (a film formation rate). In order to limit deterioration of the superconducting characteristic of the oxide superconducting layer 5, an average film thickness of the protective layer 2 that is formed at one time is preferably set to 5 µm or less. When forming the protective layer 2 whose average film thickness is greater than 5 µm, a film formation process is performed a plurality of times, and the body to be coated is cooled (or heat is dissipated) whenever the film formation process is performed. That is, a film having an average film thickness of 5 µm or less is formed, and then the film is cooled once. Then, a film having an average film thickness of 5 µm or less is formed again.

In addition, Ag of the protective layer 2 may be recrystallized due to an increase in the temperature of the body to be coated during the film formation by the sputtering method. When a film having an average film thickness of 5 µm or less is formed at one time, it is possible to limit recrystallization of Ag.

In the protective layer 2 formed in this manner, an average film thickness Tₐᵥₑ, which is an average value of a film thickness T of the protective layer 2, is 0.1 µm to 5 µm. The ratio T_{σ}/Tₐᵥₑ between a standard deviation T_{σ} and the average film thickness Tₐᵥₑ of the film thickness T is 0.4 or less.

The average film thickness Tₐᵥₑ herein refers to an average value when a film thickness of the protective layer 2 is measured at random in the longitudinal direction (the Y direction) and the width direction (the X direction) of the oxide superconducting wire 1. In addition, for example, the average film thickness Tₐᵥₑ may be obtained such that a measurement device such as a step profiler is used to continuously scan the protective layer 2 in a width direction for measurement.

When a value of the film thickness T increases, a standard deviation value Tσ thereof also increases. Therefore, it is possible to indicate whether a part whose film thickness T is extremely large and a part whose film thickness T is extremely small is formed according to the ratio of the standard deviation T_{σ} with respect to the average film thickness Tₐᵥₑ.

A low ratio T_{σ}/Tₐᵥₑ between the standard deviation T_{σ} and the average film thickness Tₐᵥₑ of the film thickness T indicates that neither the extremely thick part nor the extremely thin part is formed in the protective layer 2, and the film thickness T is stable and smooth.

In the present embodiment, when the ratio T_{σ}/Tₐᵥₑ is set to 0.4 or less, it is possible to limit the protective layer 2 from becoming excessively thick and a pinhole from being formed. Accordingly, it is possible to reduce the cost while sufficiently performing a protective function.

Since the protective layer 2 is formed to have a uniform film thickness with no aggregation of Ag, a surface is smooth and metallic luster is observed from an upper surface.

The average film thickness Tₐᵥₑ of the protective layer 2 is preferably set to 0.1 µm to 5 µm.

When wires are connected to each other by soldering on the protective layer 2, or when a stabilizing layer formed of a metal tape is formed through a solder layer, the average film thickness Tₐᵥₑ of the protective layer 2 is preferably set to 1 µm to 5 µm. When solder is provided on the protective layer 2, a metal (for example, Sn) of the solder diffuses into the protective layer 2, and an alloy layer of about 1 µm may be formed. Accordingly, when the solder is provided, the average film thickness Tₐᵥₑ of the protective layer 2 is preferably set to 1 µm or more.

When a plating coating layer is formed by a plating method on an outer circumference of the oxide superconducting wire 1 in which the protective layer 2 is formed, the average film thickness Tₐᵥₑ of the protective layer 2 is preferably set to 0.1 µm to 2.5 µm. When the wire is pretreated by the plating method, the film thickness of the protective layer 2 may be reduced by about 0.1 µm. Accordingly, when the plating coating layer is formed, the average film thickness Tₐᵥₑ of the protective layer 2 is preferably set to 0.1 µm or more.

In addition, it is possible to reduce a cost by forming the protective layer 2 to be as thin as possible. Accordingly, depending on a layer formed on the protective layer 2, it is preferable to form the protective layer 2 to be as thin as possible.

A connection between the oxide superconducting wires 1 can be implemented by the protective layers 2 being prepared to face each other and bonded by soldering. In addition, a connection to an input terminal can be implemented by soldering a terminal to the protective layer 2. In these cases, solder is directly adhered to the protective layer 2. When the solder is adhered to the protective layer 2, a metal (as an example, Sn) of the solder moves into the protective layer 2 and Ag of the protective layer 2 is formed into an alloy. For example, since Ag is alloyed with Sn and becomes brittle, when the protective layer 2 has a local thin part, there is a risk of a strength of a connection part decreasing because the thin part is alloyed in the overall thickness direction. In the film thickness T of the protective layer 2, when the average value Tₐᵥₑ is set to 0.1 µm to 5 µm, and the ratio T_{σ}/Tₐᵥₑ between the standard deviation T_{σ} and the average value Tₐᵥₑ is set to 0.4 or less, it is possible to limit the protective layer 2 from becoming brittle in the overall thickness direction and from being easily peeled off.

### <Second embodiment>

Fig. 2 is a schematic diagram showing a cross section of an oxide superconducting wire 11 according to a second embodiment of the present invention. In the oxide superconducting wire 11 according to the present embodiment, a stabilizing layer 8 is further provided around the oxide superconducting wire 1 according to the first embodiment through a solder layer 7.
In the following description of second and third embodiments, the same wire as the oxide superconducting wire 1 according to the first embodiment (refer to Fig. 1) is referred to as the oxide superconducting laminate 1A.

The stabilizing layer 8 is formed to cover the oxide superconducting laminate 1A in a substantially C shape in a cross-sectional view by a metal tape. The stabilizing layer 8 is bonded to the solder layer 7 along an outer circumference (in all directions in a cross section) of the oxide superconducting laminate 1A. An embedding part 7b in which the melted solder layer 7 is embedded is formed in a part that is not covered by the metal tape (that is, a gap between side ends of the metal tape).

The stabilizing layer 8 can be formed such that, while melting the solder layer 7, the metal tape wraps the oxide superconducting laminate 1A to form a cross section in a substantially C shape from a main surface side (the protective layer 2 side) and is subjected to a bending process by rolling. It is preferable to use a metal tape in which solder plating is performed on both surfaces or on one surface serving as an inner side in advance.

When processing is performed in this manner, the melted solder (the solder plating that is applied to the metal tape in advance) is concentrated at the gap between the side ends of the metal tape, and the embedding part 7b is formed.

As a material of the metal tape forming the stabilizing layer 8, a material having good conductivity may be used, but the material is not particularly limited. For example, as the metal tape, a relatively inexpensive material, for example, copper, copper alloys such as brass (a Cu-Zn alloy) and a Cu-Ni alloy or stainless steel is preferably used. Among them, a metal tape made of copper is preferable since it has high conductivity and is inexpensive.

In the oxide superconducting wire 11, the stabilizing layer 8 serves as a bypass through which an overcurrent generated at the time of an accident commutates. In addition, when the oxide superconducting wire 11 is used for a superconductor current limiting device, the stabilizing layer 8 is used to instantaneously limit an overcurrent caused when a quench is caused and the superconducting state transitions to a normal conduction state. In this case, as a material used for the stabilizing layer 8, for example, a high-resistant metal such as a Ni-based alloy, such as Ni-Cr, is preferably used.

The thickness of the metal tape forming the stabilizing layer 8 is not particularly limited but is appropriately adjustable, and can be set to 9 to 60 µm. When the thickness of the metal tape is too small, there is a risk of a crack occurring during a processing procedure. On the other hand, when the thickness of the metal tape is to large, it is difficult to mold a cross section in a substantially C shape, and there is a risk of the oxide superconducting layer 5 deteriorating since it is necessary to add high stress during molding.

Solder used for the solder layer 7 is not particularly limited, and solders known in the related art can be used. Among them, when solder having a melting point of 300 °C or less is used, it is possible to limit a characteristic of the oxide superconducting layer 5 from deteriorating due to the heat during soldering.

The oxide superconducting wire 11 according to the present embodiment can realize a structure in which moisture does not penetrate thereinto since the stabilizing layer 8 is formed in all directions in a cross section of the oxide superconducting laminate 1A. In addition, the stabilizing layer can be formed by spiral winding the metal tape along the outer circumference of the oxide superconducting laminate 1A. The stabilizing layer 8 may be formed on the entire outer circumference of the oxide superconducting laminate 1A. The stabilizing layer 8 may be formed on at least the protective layer 2.

When the solder layer 7 is formed on the protective layer 2, a metal (as an example, Sn) composing the solder moves into the protective layer 2, and Ag of the protective layer 2 becomes brittle. Brittleness is limited to the vicinity of an interface of the solder layer 7 in the protective layer 2. However, when the protective layer 2 has a local thin part, the protective layer 2 becomes brittle in the overall thickness direction and the metal tape is likely to be peeled off. That is, the peel strength of the stabilizing layer 8 decreases.

In the oxide superconducting wire 11 of the present embodiment, since the protective layer 2 is formed after the oxygen annealing treatment is performed, an aggregation of Ag of the protective layer 2 is limited. Therefore, there is no possibility of the protective layer 2 being locally thin. Accordingly, Ag alloying does not extend to the overall thickness direction of the protective layer 2, and it is possible to prevent the peel strength of the stabilizing layer 8 from decreasing.

### <Third embodiment>

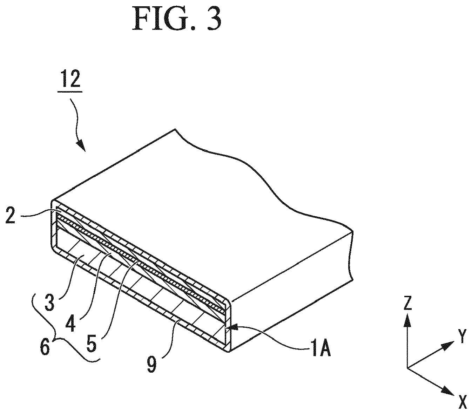

Fig. 3 is a schematic diagram of a cross section of an oxide superconducting wire 12 according to a third embodiment.

In the oxide superconducting wire 12 of the present embodiment, a plating coating layer 9 (a stabilizing layer) is further provided around the oxide superconducting wire 1 of the first embodiment (the oxide superconducting laminate 1A) by a plating method.

The plating coating layer 9 is made of a metal material having good conductivity. When the oxide superconducting layer 5 is transitioned to a normal conducting state, the plating coating layer 9 serves as a bypass along with the protective layer 2 and functions as a stabilizing layer.

In addition, the plating coating layer 9 makes it possible to completely block the oxide superconducting laminate 1A from the outside. Accordingly, it is possible to reliably prevent moisture from penetrating into the oxide superconducting layer 5. As a metal used for the plating coating layer 9, copper, nickel, gold, silver, chromium, or tin are exemplary examples, and a combination of one, two or more of such metals can be used. In addition, when the oxide superconducting wire 12 is used for the superconductor current limiting device, a material used for the plating coating layer 9 includes, for example, a high-resistant metal such as an Ni-based alloy, such as Ni-Cr.

The thickness of the plating coating layer 9 is not particularly limited but is appropriately adjustable, and is preferably set to 10 to 100 µm. When the thickness of the plating coating layer 9 is set to 10 µm or more, it is possible to reliably cover around the oxide superconducting laminate 1A. In addition, when the thickness of the plating coating layer 9 is greater than 100 µm, the oxide superconducting wire 12 is enlarged and flexibility decreases. The plating coating layer 9 may be formed along the entire outer circumference of the oxide superconducting laminate 1A. The plating coating layer 9 may be formed on at least the protective layer 2.

The plating coating layer 9 can be formed by a plating method known in the related art. That is, the oxide superconducting laminate 1A is immersed in a plating solution (in the case of electroplating, electricity is supplied to a surface of the oxide superconducting laminate 1A serving as a body to be plated while being immersed in the plating solution).

When a pinhole is formed in the protective layer 2, the oxide superconducting layer 5 exposed by the pinhole is in contact with the plating solution, and the oxide superconducting layer 5 is corroded. Therefore, there is a risk of the superconducting characteristic deteriorating.

In the oxide superconducting wire 12 according to the present embodiment, an aggregation of Ag of the protective layer 2 is limited, and no pinhole is formed. Accordingly, the superconducting characteristic does not decrease even when the oxide superconducting laminate is immersed in the plating solution.

### [Examples]

Hereinafter, the present invention according to examples will be described in further detail, but the present invention is not limited to such examples.

### <Sample preparation>

First, a surface of a tape-shaped substrate (a width of 10 mm, a thickness of 0.1 mm, and a length of 1000 mm) made of HASTELLOY C-276 (product name, commercially available from Haynes International, Inc. USA) was polished using alumina having an average particle size of 3 µm. Next, the surface of the substrate was degreased and washed with acetone.

An Al₂O₃ film (a diffusion preventing layer; a film thickness of 100 nm) was formed on a main surface of the substrate by a sputtering method. A Y₂O₃ film (a bed layer; a film thickness of 30 nm) was formed thereon by an ion beam sputtering method.

Next, on the bed layer, an MgO film (a metal oxide layer; a film thickness of 5 to 10 nm) was formed by an IBAD method, and a CeO₂ film (a cap layer, a film thickness of 500 nm) was formed thereon by a pulsed laser deposition (PLD) method. Next, a GdBa₂Cu₃O_{7-δ} film (an oxide superconducting layer, a film thickness of 2.0 µm) was formed on the CeO₂ layer by the PLD method.

A sample A prepared in this manner was used for both of the following example and comparative example.

### (Example)

The above-described sample A was subjected to oxygen annealing at 500 °C under an oxygen atmosphere for 10 hours, was cooled in a furnace for 26 hours, and then was removed therefrom.

Next, with respect to the sample, a protective layer made of Ag and having an average film thickness shown in the following Table 1 was formed on an oxide superconducting layer by a sputtering method.
In this manner, an oxide superconducting wire according to the example was prepared.

### (Comparative Example)

With respect to the above-described sample A, a protective layer made of Ag was formed on an oxide superconducting layer by the sputtering method.

Next, this sample was subjected to oxygen annealing at 500 °C under an oxygen atmosphere for 10 hours, was cooled in a furnace for 26 hours, and then was removed therefrom.

In this manner, an oxide superconducting wire according to the comparative example was prepared.

In the example and the comparative example, the order of the oxygen annealing and formation of the protective layer was different between procedures of preparing the oxide superconducting wires.

### <Evaluation>

### (Critical current characteristic)

Three oxide superconducting wires according to the example and three oxide superconducting wires according to the comparative example were prepared, and the critical current value (Ic) thereof were measured. The average value of Ic of each of the three oxide superconducting wires is as follows.

### Example: 545A

### Comparative example: 539A

Based on the above result, it can be understood that there was no significant difference between the critical current values (Ic) of the example and the comparative example. Accordingly, it was confirmed that, in the above-described manufacturing procedure, even when the protective layer was formed after the oxygen annealing treatment was performed as in the example, direct deterioration in the superconducting characteristic was not observed.

### (Measurement of an interfacial resistance)

In the oxide superconducting wire according to the example, the protective layer was formed after the oxygen annealing treatment. Accordingly, comparing the comparative example using the manufacturing method in the related art, there is a concern that an interfacial state between the oxide superconducting layer and the protective layer is changed, and a resistance value in the interface increases. Therefore, in the oxide superconducting wires according to the example and the comparative example, an interfacial resistance between the oxide superconducting layer and the protective layer was measured.

An average value of interfacial resistances that were measured using the three oxide superconducting wires that were prepared according to the example and the comparative example is as follows.

### Example: 4.2×10⁻⁸Ω·cm²

### Comparative example: 3.9×10⁻⁸Ω·cm²

Based on the above result, it can be understood that there was no significant difference of interfacial resistances between the oxide superconducting layer and the protective layer in the example and the comparative example. Accordingly, it was confirmed that, in the above-described manufacturing procedure, even when the protective layer was formed after the oxygen annealing treatment was performed as in the example, there was no significant increase in the interfacial resistance.

### (Observation using a scanning electron microscope (SEM))

The oxide superconducting wires according to the example and the comparative example were cut, and a cross section of the protective layer was observed using an SEM.

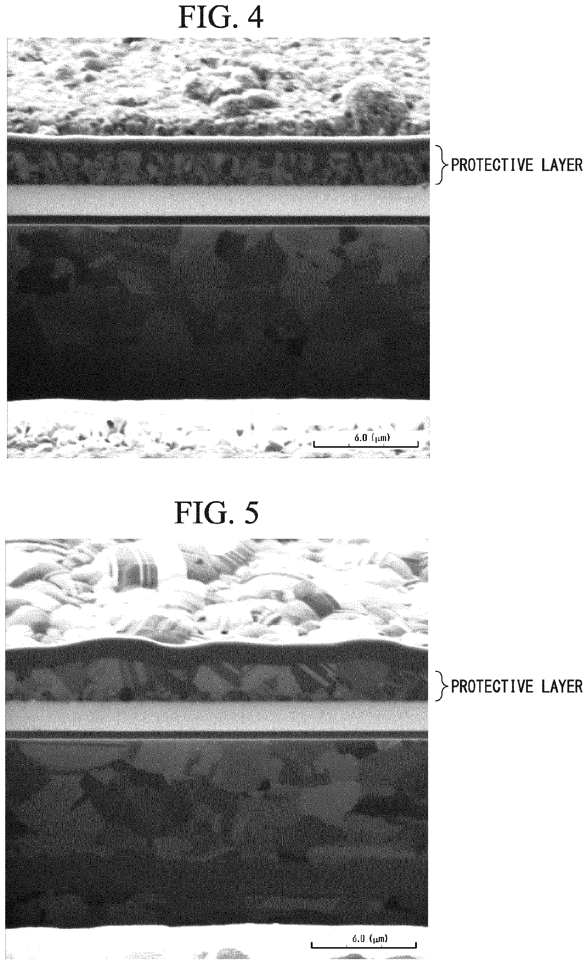

Fig. 4 shows an SEM image of a cross section of the protective layer formed in the oxide superconducting wire according to the example. Fig. 5 shows an SEM image of a cross section of the protective layer formed in the oxide superconducting wire according to the comparative example. In addition, measurement results of an average film thickness Tₐᵥₑ, a standard deviation T_{σ}, and an arithmetic average roughness Ra of the protective layers of the example and the comparative example are shown in Table 1. The average film thickness Tₐᵥₑ and the standard deviation T_{σ} were calculated based on data about a continuous film thickness obtained by continuously scanning an upper surface of the protective layer using a step profiler at steps of 1 mm. In the same manner, the arithmetic average roughness Ra of the upper surface of the protective layer was calculated using a roughness meter.

### (Peel strength)

Next, a copper tape (a width of 10 mm, a thickness of 0.1 mm, and a length of 1000 mm) was soldered to the protective layer of the oxide superconducting wires according to the example and the comparative example, and a peel strength between the copper tape and the oxide superconducting wire was measured.
For measurement, a strength at which the copper tape (the metal tape) was peeled off was measured by a stud pull peel test. The peel strength was measured such that a distal end of a stud pin having a diameter of 2.7 mm was bonded and fixed (an adhesion area of 5.72 mm2 of a pin distal end) to a surface of the copper tape using an epoxy resin, the stud pin was pulled in a vertical direction with respect to a film-forming surface of the wire, and a tensile load at a time at which a stress decreased was used as a peel stress (the peel strength).

The stud pull peel test was performed on 10 regions of the samples for measurement. The maximum value, the minimum value, and the average value of measured values are shown in the following Table 1.

**[Table 1]**

| | | Comparative Example | Example 1 | Example 2 | Example 3 |
|---|---|---|---|---|---|
| Average film thickness Tₐᵥₑ (µm) | | 3.05 | 1.61 | 2.10 | 2.24 |
| Standard deviation T_{σ} (µm) | | 2.31 | 0.07 | 0.18 | 0.76 |
| T_{σ}/Tₐᵥₑ | | 0.76 | 0.04 | 0.09 | 0.34 |
| Ra (nm) | | 178.4 | 7.9 | 8.6 | 75.8 |
| Peel force (MPa) | Average | 22.3 | 43.5 | 44.8 | 39.6 |
| | Maximum | 43.9 | 67.9 | 69.1 | 63.2 |
| | Minimum | 4.7 | 20.1 | 20.2 | 18.8 |

Comparing Fig. 4 and Fig. 5, it can be understood that the protective layer of the example (Fig. 4) was formed to have a uniform film thickness. In Fig. 4 and Fig. 5, a thin film part formed on the protective layer is a carbon deposited when a cross section was processed by a focused ion beam (FIB).

In addition, based on the results shown in Table 1, in the protective layer of the example, the ratio T_{σ}/Tₐᵥₑ between the standard deviation T_{σ} and the average film thickness Tₐᵥₑ is 0.4 or less. On the other hand, T_{σ}/Tₐᵥₑ of the comparative example is 0.76, and it can be seen that a thick part and a thin part were formed on the protective layer based on the data.

In addition, the peel strength of the example is higher than the peel strength of the comparative example. It is considered that in the oxide superconducting wire of the comparative example, since the protective layer had a nonuniform film thickness and had a thin part that was locally formed, the part was alloyed with the solder in an overall thickness direction and became brittle. On the other hand, it is considered that since the protective layer of the oxide superconducting wire according to the example was formed to have a uniform film thickness, alloying did not proceed in the overall thickness direction, and the strength was maintained.

In addition, according to the method of the present example, since an aggregation of Ag does not occur, the protective layer has a uniform film thickness distribution and T_{σ} is small. Based on the results of Table 1, in the above-described embodiment, a surface of the protective layer has an arithmetic average roughness Ra of 80 nm or less. Therefore, in the oxide superconducting wire in which the protective layer is formed after the intermediate body is subjected to the oxidation annealing treatment, a value of Ra of the surface of the protective layer made of Ag is preferably 80 nm or less. Thus, when Ra is reduced to less than 80 nm , the risk of the oxide superconducting layer being exposed is eliminated even when the protective layer is formed to have a small film thickness.

While various embodiments of the present invention have been described above, components in the embodiments and combinations thereof are only examples. Addition, omission, substitution and other changes of components can be made within the scope without departing from scope of the present invention, as defined by the appended claims.

### DESCRIPTION OF REFERENCE NUMERAL

1, 11, 12 Oxide superconducting wire 1A Oxide superconducting laminate 2 Protective layer 3 Substrate 4 Intermediate layer 5 Oxide superconducting layer 6 Intermediate body 7 Solder layer 8 Stabilizing layer 9 Plating coating layer (stabilizing layer)

## Claims

1. An oxide superconducting wire comprising an oxide superconducting laminate (1A), the oxide superconducting laminate (1A) comprising:
an intermediate body (6) that contains a tape-shaped substrate (3), an intermediate layer (4) formed on a main surface of the substrate (3) and an oxide superconducting layer (5) formed on the intermediate layer (4);
a protective layer (2) formed on the intermediate body (6); and
a plating coating layer (9) formed along an outer circumference of the oxide superconducting laminate (1A), wherein
an average film thickness Tₐᵥₑ of the protective layer (2) is 0.1 µm to 5 µm, and a ratio T_{σ}/Tₐᵥₑ between a standard deviation T_{σ} and the average film thickness Tₐᵥₑ of a film thickness of the protective layer (2) is 0.4 or less, and
when the oxide superconducting layer (5) is transitioned to a normal conducting state, the plating coating layer (9) serves as a bypass along with the protective layer (2) and functions as a stabilizing layer.

2. The oxide superconducting wire according to claim 1, wherein
the protective layer (2) is made of Ag or an Ag alloy.

3. The oxide superconducting wire according to claim 1, wherein
the protective layer (2) is configured to be formed after the intermediate body (6) is subjected to an oxygen annealing treatment.

4. The oxide superconducting wire according to claim 1, wherein
an arithmetic average roughness Ra of a surface of the protective layer (2) is 80 nm or less.

5. An oxide superconducting wire manufacturing method comprising:
preparing an intermediate body (6) comprising a substrate (3), an intermediate layer (4) formed on the substrate (3), and an oxide superconducting layer (5) formed on the intermediate layer;
performing an oxygen annealing treatment on the intermediate body (6); and
forming a protective layer (2) on the oxide superconducting layer (5) after the oxygen annealing treatment is performed.

6. The oxide superconducting wire manufacturing method according to claim 5, wherein
the protective layer (2) is made of Ag or an Ag alloy.

7. The oxide superconducting wire manufacturing method according to claim 5, wherein
when the protective layer (2) is formed, after the protective layer (2) having an average film thickness of 5 µm or less is formed by a sputtering method, the oxide superconducting wire is subjected to cooling or heat dissipation.

8. The oxide superconducting wire manufacturing method according to claim 5, wherein
when the protective layer (2) is formed, a process in which the protective layer (2) having an average film thickness of 5 µm or less is formed by a sputtering method and a process in which the oxide superconducting wire is subjected to cooling or heat dissipation are repeatedly performed.

9. The oxide superconducting wire manufacturing method according to claim 5, wherein
an arithmetic average roughness Ra of a surface of the protective layer (2) is 80 nm or less.

## Patentansprüche

1. Supraleitender Oxiddraht, der ein supraleitendes Oxidlaminat (1A) umfasst, wobei das supraleitende Oxidlaminat (1A) Folgendes umfasst:
einen Zwischenkörper (6), der ein bandförmiges Substrat (3), eine auf einer Hauptfläche des Substrats (3) gebildete Zwischenschicht (4) und eine auf der Zwischenschicht (4) gebildete supraleitende Oxidschicht (5) enthält;
eine auf dem Zwischenkörper (6) gebildete Schutzschicht (2); und
eine galvanisch hergestellte Überzugsschicht (9), die entlang eines Außenumfangs des supraleitenden Oxidlaminats (1A) gebildet ist, wobei
eine durchschnittliche Filmdicke Tₐᵥₑ der Schutzschicht (2) 0,1 µm bis 5 µm beträgt und ein Verhältnis T_{σ}/Tₐᵥₑ zwischen einer Standardabweichung T_{σ} und der durchschnittlichen Filmdicke Tₐᵥₑ einer Filmdicke der Schutzschicht (2) 0,4 oder weniger beträgt, und
wenn die supraleitende Oxidschicht (5) in einen normalleitenden Zustand übergeführt wird, die galvanisch hergestellte Überzugsschicht (9) zusammen mit der Schutzschicht (2) als Bypass dient und als Stabilisierungsschicht fungiert.

2. Supraleitender Oxiddraht nach Anspruch 1, wobei
die Schutzschicht (2) aus Ag oder einer Ag-Legierung besteht.

3. Supraleitender Oxiddraht nach Anspruch 1, wobei
die Schutzschicht (2) dazu ausgebildet ist, hergestellt zu werden, nachdem der Zwischenkörper (6) einer Glühbehandlung in Sauerstoff unterzogen worden ist.

4. Supraleitender Oxiddraht nach Anspruch 1, wobei
eine arithmetische durchschnittliche Rauigkeit Ra einer Oberfläche der Schutzschicht (2) 80 nm oder weniger beträgt.

5. Verfahren zur Herstellung eines supraleitenden Oxiddrahts, mit den folgenden Schritten:
Herstellen eines Zwischenkörpers (6), der ein Substrat (3), eine auf dem Substrat (3) gebildete Zwischenschicht (4) und eine auf der Zwischenschicht gebildete supraleitende Oxidschicht (5) umfasst;
Durchführen einer Glühbehandlung in Sauerstoff an dem Zwischenkörper (6); und
Bilden einer Schutzschicht (2) auf der supraleitenden Oxidschicht (5), nachdem die Glühbehandlung in Sauerstoff durchgeführt worden ist.

6. Verfahren zur Herstellung eines supraleitenden Oxiddrahts nach Anspruch 5, wobei
die Schutzschicht (2) aus Ag oder einer Ag-Legierung besteht.

7. Verfahren zur Herstellung eines supraleitenden Oxiddrahts nach Anspruch 5, wobei
wenn die Schutzschicht (2) gebildet wird, nachdem die Schutzschicht (2) mit einer durchschnittlichen Filmdicke von 5 µm oder weniger mit einem Sputterverfahren hergestellt wird, der supraleitende Oxiddraht einer Abkühlung oder Wärmeableitung unterzogen wird.

8. Verfahren zur Herstellung eines supraleitenden Oxiddrahts nach Anspruch 5, wobei
wenn die Schutzschicht (2) gebildet wird, ein Vorgang, bei dem die Schutzschicht (2) mit einer durchschnittlichen Filmdicke von 5 µm oder weniger mit einem Sputterverfahren hergestellt wird, und ein Vorgang, bei dem der supraleitende Oxiddraht einer Abkühlung oder Wärmeableitung unterzogen wird, wiederholt durchgeführt werden.

9. Verfahren zur Herstellung eines supraleitenden Oxiddrahts nach Anspruch 5, wobei
eine arithmetische durchschnittliche Rauigkeit Ra einer Oberfläche der Schutzschicht (2) 80 nm oder weniger beträgt.

## Revendications

1. Fil supraconducteur de type oxyde comprenant un stratifié supraconducteur de type oxyde (1A), le stratifié supraconducteur de type oxyde (1A) comprenant :
un corps intermédiaire (6) qui contient un substrat en forme de ruban (3), une couche intermédiaire (4) formée sur une surface principale du substrat (3) et une couche supraconductrice de type oxyde (5) formée sur la couche intermédiaire (4) ;
une couche protectrice (2) formée sur le corps intermédiaire (6) ; et
une couche de revêtement de placage (9) formée le long d'une circonférence externe du stratifié supraconducteur de type oxyde (1A), dans lequel
une épaisseur de film moyenne Tₐᵥₑ de la couche protectrice (2) est de 0,1 µm à 5 µm, et un rapport T_{σ}/Tₐᵥₑ entre un écart type T_{σ} et l'épaisseur de film moyenne Tₐᵥₑ d'une épaisseur de film de la couche protectrice (2) est de 0,4 ou moins, et
lorsque la couche supraconductrice de type oxyde (5) transite vers un état conducteur normal, la couche de revêtement de placage (9) sert de dérivation conjointement avec la couche protectrice (2) et fonctionne comme une couche stabilisatrice.

2. Fil supraconducteur de type oxyde selon la revendication 1, dans lequel la couche protectrice (2) est faite d'Ag ou d'un alliage d'Ag.

3. Fil supraconducteur de type oxyde selon la revendication 1, dans lequel la couche protectrice (2) est configurée pour être formée après que le corps intermédiaire (6) est soumis à un traitement de recuit sous oxygène.

4. Fil supraconducteur de type oxyde selon la revendication 1, dans lequel une rugosité moyenne arithmétique Ra d'une surface de la couche protectrice (2) est de 80 nm ou moins.

5. Procédé de fabrication de fil supraconducteur de type oxyde comprenant :
la préparation d'un corps intermédiaire (6) comprenant un substrat (3), une couche intermédiaire (4) formée sur le substrat (3), et une couche supraconductrice de type oxyde (5) formée sur la couche intermédiaire ;
la réalisation d'un traitement de recuit sous oxygène sur le corps intermédiaire (6) ; et
la formation d'une couche protectrice (2) sur la couche supraconductrice de type oxyde (5) après que le traitement de recuit sous oxygène est réalisé.

6. Procédé de fabrication de fil supraconducteur de type oxyde selon la revendication 5, dans lequel
la couche protectrice (2) est faite d'Ag ou d'un alliage d'Ag.

7. Procédé de fabrication de fil supraconducteur de type oxyde selon la revendication 5, dans lequel
lorsque la couche protectrice (2) est formée, après que la couche protectrice (2) ayant une épaisseur de film moyenne de 5 µm ou moins est formée par un procédé de pulvérisation cathodique, le fil supraconducteur de type oxyde est soumis à un refroidissement ou à une dissipation de chaleur.

8. Procédé de fabrication de fil supraconducteur de type oxyde selon la revendication 5, dans lequel
lorsque la couche protectrice (2) est formée, un processus dans lequel la couche protectrice (2) ayant une épaisseur de film moyenne de 5 µm ou moins est formée par un procédé de pulvérisation cathodique et un processus dans lequel le fil supraconducteur de type oxyde est soumis à un refroidissement ou une dissipation de chaleur sont réalisés de façon répétée.

9. Procédé de fabrication de fil supraconducteur de type oxyde selon la revendication 5, dans lequel
une rugosité moyenne arithmétique Ra d'une surface de la couche protectrice (2) est de 80 nm ou moins.
